# FASCICULE DE BREVET EUROPEEN

(11) **EP 2 710 387 B1**
(45) Date de publication et mention de la délivrance du brevet: **01.07.2015**
(21) Numéro de dépôt: 12728681.3
(22) Date de dépôt: 14.05.2012
(51) Int. Cl.: G01R 27/20, B60L 3/00, B60L 11/18, G01N 27/04, G01R 31/02

(54) **DISPOSITIF ET PROCEDE D'ESTIMATION DE LA RESISTANCE DU RACCORDEMENT A LA TERRE D'UN APPAREIL ELECTRIQUE**
VORRICHTUNG UND VERFAHREN ZUR SCHÄTZUNG DES WIDERSTANDES DES ERDSCHLUSSES EINER ELEKTRISCHEN VORRICHTUNG
DEVICE AND METHOD FOR ESTIMATING THE RESISTANCE OF THE EARTH CONNECTION OF AN ELECTRICAL APPARATUS

(30) Priorité: 19.05.2011 FR 1154382; 25.05.2011 US 201161489716 P
(43) Date de publication de la demande: 26.03.2014
(73) Titulaire: Renault S.A.S., 92100 Boulogne-Billancourt (FR)
(72) Inventeur: RIPOLL, Christophe, F-78460 Chevreuse (FR); CAUMON, Pascal, F-78120 Rambouillet (FR)
(86) Numéro de dépôt international: PCT/FR2012/051072
(87) Numéro de publication internationale: WO 2012/156635

(56) Documents cités:
- EP-A1- 0 864 873
- EP-A2- 0 915 347
- WO-A1-2010/113936
- DE-U1-202009 017 058
- GB-A- 2 191 591
- JP-A- 2001 242 206
- US-B1- 6 271 668

## Description

L'invention concerne le raccordement à la terre des appareils électriques et plus particulièrement l'estimation de la résistance du raccordement à la terre de ces appareils.

Lors du raccordement à un réseau d'alimentation électrique de certains appareils électriques, un courant de fuite destiné à être redirigé vers la terre peut apparaitre. A titre d'exemple, les chargeurs des batteries des véhicules automobiles à traction électrique ou hybride ne sont pas isolés et peuvent, lors de leur raccordement à un réseau d'alimentation électrique, faire apparaître un courant de fuite.

Le courant de fuite peut faire apparaître un courant de toucher sur le châssis électrique des appareils, si le raccordement à la terre est rompu ou si la résistance du raccordement à la terre est trop élevée. Ce courant de toucher est dangereux pour un utilisateur entrant en contact avec le châssis électrique de l'appareil, dans le cas où la résistance du raccordement à la terre est trop importante et si le passage du courant à travers l'utilisateur est favorisé.

Il est donc nécessaire d'estimer la résistance du raccordement à la terre, comme dans le document GB 2 191 591 A, avant d'autoriser l'utilisation de l'appareil électrique à la puissance nominale correspondant à la génération de forts courants de fuite. On parlera également de qualité de la terre. Un raccordement de bonne qualité a par exemple une résistance faible.

L'invention a donc pour but de fournir une estimation de la résistance du raccordement à la terre d'un appareil électrique.

Selon un aspect, il est proposé un dispositif d'estimation de la résistance du raccordement à la terre d'un appareil électrique, lorsque ledit appareil électrique est raccordé à un réseau d'alimentation électrique et également raccordé à la terre par une résistance additionnelle, ledit appareil électrique comportant au moins une impédance d'entrée, ledit dispositif d'estimation étant caractérisé en ce qu'il comprend un générateur de tension comportant des moyens de connexion à ladite impédance d'entrée et des moyens de connexion audit raccordement à la terre, des moyens de mesure du courant circulant vers la terre à travers ladite résistance du raccordement à la terre lorsque lesdits moyens de connexion à ladite impédance d'entrée et audit raccordement à la terre sont activés, et des moyens de calcul aptes à obtenir un ordre de grandeur de la résistance du raccordement à la terre en fonction dudit courant circulant vers la terre, par rapport à la valeur de ladite résistance additionnelle.

L'impédance peut être une capacité disposée en entrée de l'appareil électrique ou encore l'impédance d'entrée d'un filtre disposé en entrée de l'appareil électrique. Une estimation préalable de cette impédance d'entrée permet de déterminer le courant injecté par le générateur de tension, c'est pourquoi le courant injecté est fonction de la résistance de raccordement à la terre.

La résistance additionnelle et la résistance du raccordement à la terre sont montées en parallèle. Cette résistance additionnelle peut notamment être un autre objet en contact avec l'appareil électrique et lui-même raccordé à la terre. Cette résistance additionnelle est différente de la résistance de raccordement à la terre. Elle est a priori non voulue.

Le générateur de tension permet de faire circuler un courant à travers la résistance du raccordement à la terre, afin de mesurer le courant circulant vers la terre et d'estimer la résistance du raccordement à la terre. Le raccordement de ce générateur de tension à l'impédance est particulièrement avantageux et permet également de faire circuler un courant à travers la résistance du raccordement à la terre et de le faire reboucler dans les phases du raccordement au réseau électrique, l'impédance étant connectée aux différentes phases.

Le dispositif peut comprendre en outre des moyens de mesure du courant de fuite à partir du courant différentiel d'alimentation dudit appareil électrique, et les moyens de calcul peuvent être aptes à estimer la résistance additionnelle en fonction du courant de fuite et du courant circulant vers la terre.

La différence entre les courants de fuite et les courants circulant vers la terre permet d'obtenir le courant circulant dans la résistance additionnelle.

L'estimation des deux résistances, la résistance du raccordement à la terre et la résistance additionnelle, permet de déterminer le chemin qui sera emprunté par le courant. Dans le cas où un autre objet raccordé à la terre est en contact avec l'appareil électrique, si le raccordement à la terre est de mauvaise qualité alors le courant circulera à travers la résistance additionnelle de l'autre objet.

Les moyens de calcul peuvent comprendre une table comportant des valeurs de résistance du raccordement à la terre, des valeurs de résistance additionnelle et des valeurs de courant circulant vers la terre correspondant auxdites valeurs de résistance du raccordement à la terre et auxdites valeurs de résistance additionnelle.

Ainsi, ces valeurs tabulées permettent, au moyen des estimations des résistances, d'obtenir une estimation de la qualité du raccordement à la terre. Une étape préalable de calibration peut permettre d'obtenir ces valeurs tabulées.

En outre, l'impédance peut être l'impédance d'entrée d'un filtre de compatibilité électromagnétique. On connecte donc le générateur de tension à l'impédance d'entrée de ce filtre de compatibilité électromagnétique.

On peut ainsi utiliser les composants de ce filtre pour charger la source de tension et pour faire circuler un courant à travers la résistance du raccordement à la terre se rebouclant vers les phases, par exemple à travers des capacités de mode commun d'un filtre de compatibilité électromagnétique. L'utilisation des composants déjà présents au sein du filtre permet de réduire le coût du dispositif.

Avantageusement, le générateur de tension est un oscillateur contrôlé en tension. On peut ainsi choisir une fréquence permettant au courant de circuler dans un chemin de moindre impédance entre le filtre et le réseau. La mesure du courant de fuite est ainsi toujours fonction de la résistance du raccordement à la terre.

Le dispositif peut comprendre des moyens d'interdiction de l'utilisation de l'appareil électrique en fonction de l'estimation de la résistance du raccordement à la terre.

Si le raccordement à la terre est de mauvaise qualité, alors on peut interdire l'utilisation de l'appareil électrique, afin de protéger un utilisateur.

Avantageusement, l'appareil électrique peut être un chargeur de batterie pour véhicule automobile à traction électrique ou hybride.

On peut ainsi estimer la résistance du raccordement à la terre de ce chargeur, ainsi que la résistance additionnelle, par exemple celle d'un pont élévateur disposé sous le véhicule automobile électrique.

Selon un autre aspect, il est proposé un procédé d'estimation de la résistance du raccordement à la terre d'un appareil électrique lorsque ledit appareil électrique est raccordé à un réseau d'alimentation électrique et également raccordé à la terre par une résistance additionnelle.

Selon une caractéristique générale du procédé, on génère un courant entre une impédance d'entrée de l'appareil électrique et la résistance du raccordement à la terre et l'on mesure le courant circulant vers la terre à travers ladite résistance du raccordement à la terre, afin d'obtenir un ordre de grandeur de la résistance du raccordement à la terre par rapport à la valeur de ladite résistance additionnelle.

Avantageusement, on mesure le courant de fuite à partir du courant différentiel d'alimentation électrique et l'on estime la résistance additionnelle en fonction du courant de fuite et du courant circulant vers la terre.

On peut estimer la résistance du raccordement à la terre et la résistance additionnelle au moyen d'une table comportant des valeurs de résistance du raccordement à la terre, des valeurs de résistance additionnelle et des valeurs de courant circulant vers la terre correspondant auxdites valeurs de résistance du raccordement à la terre et auxdites valeurs de résistance additionnelle.

En outre, on peut générer une tension sinusoïdale à travers la résistance du raccordement à la terre.

On peut interdire l'utilisation de l'appareil électrique en fonction de l'estimation de la résistance du raccordement à la terre.

Avantageusement, on interdit l'utilisation de l'appareil électrique si la résistance du raccordement à la terre est plus élevée que la résistance additionnelle.

D'autres avantages et caractéristiques de l'invention apparaîtront à l'étude de la description suivante, prise à titre d'exemple non limitatif et illustrée par les dessins annexés sur lesquels:
- la figure 1 illustre un appareil électrique raccordé à un réseau d'alimentation électrique,
- la figure 2 illustre un mode de réalisation d'un dispositif selon l'invention, et
- la figure 3 illustre un mode de réalisation d'un dispositif selon l'invention raccordé à un filtre de compatibilité électromagnétique.

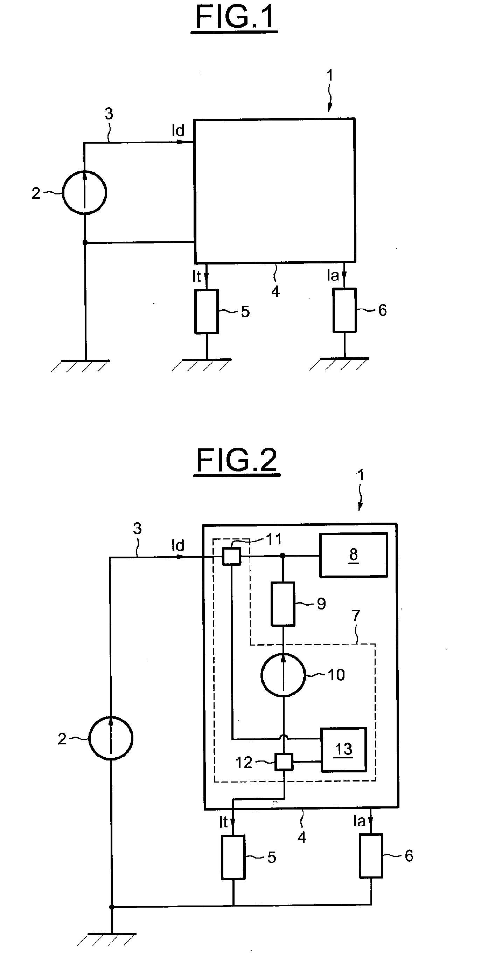

Sur la figure 1, on a représenté un appareil électrique 1 raccordé à une source de tension 2, par exemple un réseau d'alimentation électrique monophasé ou triphasé. L'appareil électrique 1 peut être par exemple un chargeur de batterie pour un véhicule automobile à traction électrique ou hybride. L'appareil électrique 1 est relié à la source de tension 2 par une connexion électrique 3 pouvant comprendre une pluralité de phases et éventuellement une connexion neutre.

L'appareil électrique 1 peut être raccordé à la terre, par exemple par son châssis électrique 4. On a représenté sur la figure la résistance du raccordement à la terre par la résistance 5.

Dans l'exemple illustré, un autre objet est en contact avec le châssis électrique 4, et forme une connexion à la terre en parallèle à celle de la connexion à la terre à travers la résistance 5, la connexion à la terre additionnelle étant représentée par la résistance additionnelle 6.

L'appareil électrique 1 est alimenté par un courant différentiel Id, permettant notamment de déterminer le courant de fuite. Ce courant de fuite peut circuler vers la terre à travers la résistance du raccordement à la terre 5 et/ou la résistance additionnelle 6. Ainsi, le courant de fuite forme un courant It circulant à travers la résistance 5 et un courant Ia circulant à travers la résistance additionnelle 6. Si la résistance du raccordement à la terre est trop importante, le courant de fuite est au moins partiellement redirigé vers la résistance additionnelle 6 par le courant Ia.

Sur la figure 2, on a représenté un appareil électrique 1 équipé d'un dispositif d'estimation de la résistance du raccordement à la terre 7, selon un mode de réalisation de l'invention.

L'appareil électrique 1 comprend un organe principal 8, disposé dans le châssis électrique 4, et raccordé à un réseau d'alimentation électrique par la connexion 3. De manière classique, un filtre de compatibilité électromagnétique 9 peut être disposé en entrée de l'appareil électrique 1, avant l'organe principal 8.

Un dispositif 7 comprenant notamment un générateur de tension 10 est disposé entre l'impédance d'entrée du filtre de compatibilité électromagnétique 9 et la terre, à travers la résistance du raccordement à la terre 5.

Des moyens de mesure 11 du courant de fuite sont disposés sur la connexion 3. Ces moyens de mesure 11 peuvent comprendre un tore bobiné traversé par les fils de phase et le neutre, de manière à obtenir la valeur du courant de fuite de manière classique. Des moyens de mesure 12 du courant It circulant vers la terre peuvent également être disposés après le générateur de tension 10 et avant le raccordement à la terre par la résistance du raccordement à la terre 5. La mesure du courant de fuite est ainsi faite par exemple à la manière de l'état de l'art: un tore de mesure de courant par lequel les phases d'alimentation passent dans le noyau. Les fuites ainsi mesurées sont la somme du courant injecté dans la résistance de raccordement 5 à la terre et celle passant dans la résistance additionnelle 6. Cette mesure de courant de fuite permet de compléter la mesure de courant dans la résistance de raccordement 5, et ainsi de faire une évaluation du rapport des résistance de raccordement 5 et de la résistance additionnelle 6 par le tableau 2 cité en exemple.

Ce rapport d'impédance permet en plus de la mesure du courant seul, de définir un critère d'autorisation d'utilisation de l'appareil électrique: par exemple si l'on n'autorise pas à charger en dessous de 5 mA, le tableau 1, interdit pour le couple (10 , 10) et (100, 100). Par contre le couple (10,10) permet quand même avec une bonne qualité de terre: le second tableau permet de discriminer ce couple pour autoriser l'utilisation de l'appareil.

Les moyens de mesure du courant de fuite et les moyens de mesure du courant circulant vers la terre sont connectés à des moyens de calcul 13. Ces moyens de calcul peuvent estimer la résistance du raccordement à la terre ainsi que la résistance additionnelle, en fonction du courant de fuite et du courant It circulant vers la terre. Les moyens de calcul 13 peuvent notamment contenir une table comportant des valeurs de résistance du raccordement à la terre 5, des valeurs de résistance additionnelle 6 et des valeurs de courant It circulant vers la terre correspondant auxdites valeurs de résistance du raccordement à la terre 5 et de résistance additionnelle 6.

On notera que le courant Ia circulant à travers la résistance additionnelle 6 est obtenu en calculant la différence du courant de fuite et du courant It circulant vers la terre.

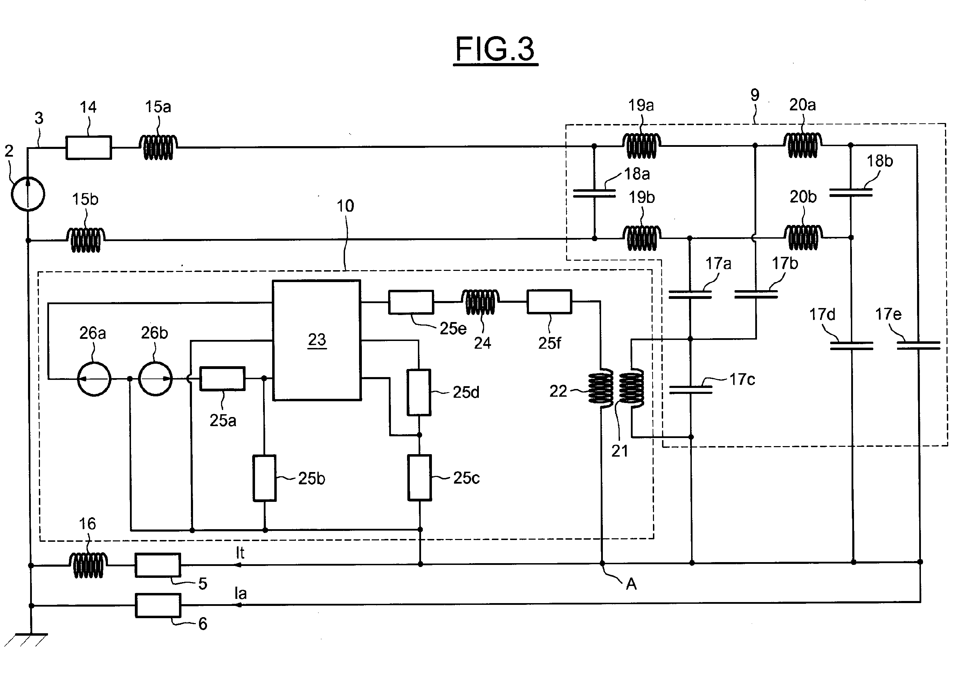

Sur la figure 3, on a représenté de manière détaillée un exemple de réalisation du générateur de tension 10 raccordé à l'impédance d'entrée du filtre de compatibilité électromagnétique 9. La connexion 3 comprend ici une résistance 14 et deux inductances 15a et 15b à cause du câblage utilisé pour le raccordement au réseau d'alimentation électrique. Par ailleurs, la connexion 3 ne comporte qu'une phase sur le mode de réalisation de la figure 3. Le raccordement à la masse comprend également une inductance 16 à cause du câblage utilisé, disposée en série avec la résistance 5.

Le filtre de compatibilité électromagnétique 9 comprend de manière classique une pluralité de capacités et d'inductances. Le filtre de compatibilité électromagnétique 9 comprend notamment des capacités de mode commun 17a, 17b, 17c, 17d et 17e, des capacités de mode différentiel 18a et 18b, des inductances de mode commun 19a et 19b et des inductances de mode différentiel 20a et 20b.

Le générateur de tension 10 comprend notamment un enroulement primaire 21 d'un transformateur disposé en parallèle avec la capacité de mode commun 17c, et un enroulement secondaire 22 destiné à alimenter un oscillateur 23 contrôlé en tension. Une inductance 24 est disposée en série entre l'oscillateur contrôlé en tension 23 et l'enroulement secondaire 22, et permet d'injecter un courant sinusoïdal dans la terre.

Un certain nombre de résistances 25a, 25b, 25c, 25d, 25e et 25f sont utilisées pour contrôler l'oscillateur 23, ainsi que deux générateurs de tension 26a et 26b.

Le générateur de tension 10 peut ainsi utiliser la capacité de mode commun 17c pour faire circuler un courant vers la terre à partir du point A, et reboucler ce courant vers les phases au moyen des capacités de mode commun 17a et 17b.

Le courant It circulant vers la terre est mesuré, ainsi qu'éventuellement le courant de fuite, et les moyens de calcul 13 estiment ensuite, par exemple au moyen d'une table, les valeurs de la résistance du raccordement à la terre 5 et de la résistance additionnelle 6.

A titre d'exemple, on peut mesurer des valeurs du courant circulant vers la terre en milliampère lors d'une étape de calibration de manière à obtenir le tableau suivant :

| Courant circulant vers la terre en milliampère | | Résistance du raccordement à la terre en ohm | | | | |
|---|---|---|---|---|---|---|
| | | 10 | 100 | 1000 | 5000 | 100000 |
| Résistance additionnelle en ohm | 10 | 5 | 1 | 0.01 | 0.02 | 0 |
| | 100 | 9 | 3.3 | 0.5 | 0.1 | 0 |
| | 1000 | 9 | 5 | 0.8 | 0.2 | 0.01 |
| | 10000 | 9 | 5.1 | 1 | 0.2 | 0.01 |
| | 100000 | 9 | 5.2 | 1 | 0.2 | 0.02 |

Ainsi, les moyens de calcul peuvent, en fonction du courant circulant vers la terre, estimer la résistance du raccordement à la terre et éventuellement la résistance additionnelle. On notera que le courant circulant vers la terre est plus important pour les raccordements à la terre de bonne qualité.

Les moyens de calcul peuvent également contenir d'autres tables, par exemple une table du courant de fuite, ou une table comprenant le rapport entre le courant de fuite et le courant circulant vers la terre. A titre d'exemple, on obtient le tableau suivant :

| Rapport entre le courant de fuite et le courant circulant vers la terre | | Résistance du raccordement à la terre en ohm | | | | |
|---|---|---|---|---|---|---|
| | | 10 | 100 | 1000 | 5000 | 100000 |
| Résistance additionnelle en ohm | 10 | 0.5 | 0.153 | 0.001 | 0.002 | 0 |
| | 100 | 1 | 0.471 | 0.5 | 0.018 | 0 |
| | 1000 | 1 | 0.909 | 0.8 | 0.02 | 0.01 |
| | 10000 | 1 | 0.962 | 1 | 0.667 | 0.1 |
| | 100000 | 1 | 1 | 1 | 1 | 1 |

Ainsi, un rapport égal à 1 correspond à un raccordement à la terre de qualité, dans lequel tout le courant de fuite circule vers la terre par le raccordement à la terre et non par la résistance additionnelle.

Avantageusement, les moyens de calcul sont connectés à des moyens d'interdiction de l'utilisation de l'appareil électrique, non illustrés sur les figures, permettant d'empêcher le fonctionnement de l'appareil électrique lorsque le raccordement n'est pas de bonne qualité.

Par exemple, pour un chargeur de véhicule automobile électrique, on pourra empêcher la charge du véhicule si le raccordement à la terre est de mauvaise qualité, et ainsi protéger les utilisateurs contre d'éventuels courants de toucher.

On peut cependant autoriser la charge pour un mauvais raccordement à la terre, si la résistance additionnelle permet au courant de circuler vers la terre et est connue.

On notera que l'on peut mettre en oeuvre l'estimation de la qualité du raccordement à la terre de manière continue ou dynamique, de manière à prendre en compte les modifications de la résistance additionnelle.

Il est à noter que dans ce mode de réalisation de l'invention, le réseau d'alimentation électrique 2 est connecté à la terre du côté du transformateur. Dans d'autres modes de réalisation de l'invention, le réseau est par exemple de type IT (réseau d'alimentation isolé de la terre), et il y aura également une évaluation de la résistance 5 de raccordement à la terre par le dispositif de mesure.

Le but de l'invention n'est en effet pas de faire une mesure de la résistance 5 de raccordement à la terre, mais de faire une évaluation de son ordre de grandeur par rapport à la résistance additionnelle 6. Ceci peut se faire par la mesure du courant 12 et du calculateur 13.

Sur une bonne terre (0 Ohms), le courant injecté est connu car le générateur de courant est dimensionné avec une valeur et une tolérance connue comme par exemple dans le tableau 1 (9 mA) . Une mauvaise terre à 1000 Ohms (réseau en régime IT par exemple) fera chuter le courant injecté à 1 mA. Une mauvaise terre à 10000 Ohms fera chuter le courant à 0.02 mA: valeur représentative d'une prise de terre non connectée à la terre.

D'autre par, le courant mesuré permet aussi de faire l'évaluation d'une terre parallèle non connectée par la prise d'alimentation: une terre à 100 ohms avec une terre parallèle de 100 Ohms fera chuter le courant à 3.3mA.

On est donc en mesure d'évaluer les bonnes prise de terre (jusqu'à 100 Ohms) ainsi qu'une évaluation d'une prise de terre en parallèle ne passant pas par la prise de terre de la prise de tension d'alimentation du dispositif.

## Revendications

1. Dispositif (7) d'estimation de la résistance du raccordement à la terre (5) d'un appareil électrique (1), lorsque ledit appareil électrique est raccordé à un réseau d'alimentation électrique et également raccordé à la terre par une résistance additionnelle (6), ledit appareil électrique comportant au moins une impédance (9) d'entrée, ledit dispositif d'estimation étant **caractérisé en ce qu'**il comprend un générateur de tension (10) comportant des moyens de connexion à ladite impédance d'entrée et des moyens de connexion audit raccordement à la terre, des moyens de mesure (12) du courant circulant vers la terre (It) à travers ladite résistance (5) du raccordement à la terre lorsque lesdits moyens de connexion à ladite impédance d'entrée et audit raccordement à la terre sont activés, et des moyens de calcul (13) aptes à obtenir un ordre de grandeur de la résistance du raccordement à la terre (5) en fonction dudit courant circulant vers la terre (It), par rapport à la valeur de ladite résistance additionnelle (6),
le dispositif comprenant en outre des moyens de mesure du courant de fuite (11) à partir du courant différentiel d'alimentation dudit appareil électrique, et dans lequel les moyens de calcul (13) sont aptes à estimer la résistance additionnelle (6) en fonction du courant de fuite et du courant circulant vers la terre (It),
les moyens de calcul (13) comprenant une table comportant des valeurs de résistance du raccordement à la terre (5), des valeurs de résistance additionnelle (6) et des valeurs de courant circulant vers la terre correspondant auxdites valeurs de résistance du raccordement à la terre et auxdites valeurs de résistance additionnelle.

2. Dispositif selon la revendication 1, dans lequel ladite impédance est l'impédance d'entrée d'un filtre de compatibilité électromagnétique.

3. Dispositif selon l'une quelconque des revendications précédentes, dans lequel le générateur de tension (10) est un oscillateur contrôlé en tension.

4. Dispositif selon l'une quelconque des revendications précédentes, comprenant des moyens d'interdiction de l'utilisation de l'appareil électrique (1) en fonction de l'estimation de la résistance du raccordement à la terre (5).

5. Dispositif selon l'une quelconque des revendications précédentes, dans lequel l'appareil électrique (1) est un chargeur de batterie pour véhicule automobile à traction électrique ou hybride.

6. Procédé d'estimation de la résistance du raccordement à la terre (5) d'un appareil électrique (1) lorsque ledit appareil électrique est raccordé à un réseau d'alimentation électrique et également raccordé à la terre par une résistance additionnelle (6), ledit procédé d'estimation étant **caractérisé en ce qu'**on génère un courant entre une impédance d'entrée de l'appareil électrique et la résistance du raccordement à la terre (5) et que l'on mesure le courant circulant vers la terre (It) à travers ladite résistance du raccordement à la terre (5), afin d'obtenir un ordre de grandeur de la résistance du raccordement à la terre (5) par rapport à la valeur de ladite résistance additionnelle (6),
on mesure le courant de fuite à partir du courant différentiel d'alimentation électrique, et l'on estime la résistance additionnelle (6) en fonction du courant de fuite et du courant circulant vers la terre (It), et on estime la résistance du raccordement à la terre (5) et la résistance additionnelle au moyen d'une table comportant des valeurs de résistance du raccordement à la terre (5), des valeurs de résistance additionnelle (6) et des valeurs de courant circulant vers la terre correspondant auxdites valeurs de résistance du raccordement à la terre et auxdites valeurs de résistance additionnelle.

7. Procédé selon la revendication 6, dans lequel on génère un courant sinusoïdal à travers la résistance du raccordement à la terre (5).

8. Procédé selon l'une quelconque des revendications 6 ou 7, dans lequel on interdit l'utilisation de l'appareil électrique (1) en fonction de l'estimation de la résistance du raccordement à la terre.

9. Procédé selon la revendication 8, dans lequel on interdit l'utilisation de l'appareil électrique (1) si la résistance du raccordement à la terre est plus élevée que la résistance additionnelle.

## Patentansprüche

1. Vorrichtung (7) zur Schätzung des Widerstands des Erdanschlusses (5) einer elektrischen Vorrichtung (1), wenn die elektrische Vorrichtung an ein Stromversorgungsnetz angeschlossen ist und auch über einen zusätzlichen Widerstand (6) an die Erde angeschlossen ist, wobei die elektrische Vorrichtung mindestens eine Eingangsimpedanz (9) aufweist, wobei die Vorrichtung zur Schätzung **dadurch gekennzeichnet ist, dass** sie einen Spannungsgenerator (10) aufweist, der Mittel zum Anschließen an die Eingangsimpedanz und Mittel zum Anschließen an den Erdanschluss, Mittel zum Messen (12) des Stroms, der durch den Widerstand (5) des Erdanschlusses zur Erde fließt (It), wenn die Mittel zum Anschließen an die Eingangsimpedanz und an den Erdanschluss aktiviert sind, und Mittel zum Berechnen (13) aufweist, die geeignet sind, eine Größenordnung des Widerstandes des Erdanschlusses (5) in Abhängigkeit von dem Strom, der zur Erde fließt (It), gegenüber dem Wert des zusätzlichen Widerstands (6) zu erhalten,
wobei die Vorrichtung außerdem Mittel zum Messen des Kriechstroms (11) von dem Differenzstrom der Versorgung der elektrischen Vorrichtung aufweist, und wobei die Mittel zum Berechnen (13) geeignet sind, den zusätzlichen Widerstand (6) in Abhängigkeit von dem Kriechstrom und dem Strom, der zur Erde fließt (It), zu schätzen,
wobei die Mittel zum Berechnen (13) eine Tabelle aufweisen, die Werte des Widerstands des Erdanschlusses (5), Werte des zusätzlichen Widerstands (6) und Werte des Stroms, der zur Erde fließt, aufweist, die den Werten des Widerstands des Erdanschlusses und den Werten des zusätzlichen Widerstands entsprechen.

2. Vorrichtung nach Anspruch 1, wobei die Impedanz die Eingangsimpedanz eines elektromagnetischen Kompatibilitätsfilters ist.

3. Vorrichtung nach einem der vorhergehenden Ansprüche, wobei der Spannungsgenerator (10) ein spannungsgesteuerter Oszillator ist.

4. Vorrichtung nach einem der vorhergehenden Ansprüche, die Mittel zum Verhindern der Verwendung der elektrischen Vorrichtung (1) in Abhängigkeit von der Schätzung des Widerstands des Erdanschlusses (5) aufweist.

5. Vorrichtung nach einem der vorhergehenden Ansprüche, wobei die elektrische Vorrichtung (1) ein Batterieladegerät für ein Kraftfahrzeug mit elektrischem Antrieb oder mit Hybridantrieb ist.

6. Verfahren zur Schätzung des Widerstands des Erdanschlusses (5) einer elektrischen Vorrichtung (1), wenn die elektrische Vorrichtung an ein Stromversorgungsnetz angeschlossen ist und auch über einen zusätzlichen Widerstand (6) an die Erde angeschlossen ist, wobei das Verfahren zur Schätzung **dadurch gekennzeichnet ist, dass** ein Strom zwischen einer Eingangsimpedanz der elektrischen Vorrichtung und dem Widerstand des Erdanschlusses (5) erzeugt wird, und dass der Strom, der zur Erde fließt (It), über den Widerstand des Erdanschlusses (5) gemessen wird, um eine Größenordnung des Widerstands des Erdanschlusses (5) in Bezug auf den Wert des zusätzlichen Widerstands (6) zu erhalten, dass der Kriechstrom ausgehend von dem Differenzstrom der Stromversorgung gemessen wird, und dass der zusätzliche Widerstand (6) in Abhängigkeit von dem Kriechstrom und dem Strom, der zur Erde fließt (It), geschätzt wird, und dass der Widerstand des Erdanschlusses (5) und der zusätzliche Widerstand mittels einer Tabelle geschätzt werden, die Werte des Widerstands des Erdanschlusses (5), Werte des zusätzlichen Widerstands (6) und Werte des Stroms, der zur Erde fließt, aufweist, die den Werten des Widerstands des Erdanschlusses und den Werten des zusätzlichen Widerstands entsprechen.

7. Verfahren nach Anspruch 6, wobei ein sinusförmiger Strom durch den Widerstand des Erdanschlusses (5) erzeugt wird.

8. Verfahren nach einem der Ansprüche 6 oder 7, wobei die Verwendung der elektrischen Vorrichtung (1) in Abhängigkeit von der Schätzung des Widerstands des Erdanschlusses verhindert wird.

9. Verfahren nach Anspruch 8, wobei die Verwendung der elektrischen Vorrichtung (1) verhindert wird, wenn der Widerstand des Erdanschlusses höher als der zusätzliche Widerstand ist.

## Claims

1. Device (7) for estimating the resistance of the earth connection (5) of an electrical apparatus (1), when the said electrical apparatus is connected to an electrical supply network and also connected to the earth by an additional resistance (6), the said electrical apparatus comprising at least one input impedance (9), the said estimating device being **characterized in that** it comprises a voltage generator (10) comprising means of linking to the said input impedance and means of linking to the said earth connection, means of measurement (12) of the current flowing to earth (It) across the said resistance (5) of the earth connection when the said means of linking to the said input impedance and to the said earth connection are activated, and calculation means (13) able to obtain an order of magnitude of the resistance of the earth connection (5) as a function of the said current flowing to earth (It), with respect to the value of the said additional resistance (6),
the device furthermore comprising means for measuring the leakage current (11) on the basis of the differential supply current for powering the said electrical apparatus, and in which the calculation means (13) are able to estimate the additional resistance (6) as a function of the leakage current and of the current flowing to earth (It),
the calculation means (13) comprising a table comprising values of resistance of the earth connection (5), values of additional resistance (6) and values of current flowing to earth corresponding to the said values of resistance of the earth connection and to the said values of additional resistance.

2. Device according to Claim 1, in which the said impedance is the input impedance of an electromagnetic compatibility filter.

3. Device according to any one of the preceding claims, in which the voltage generator (10) is a voltage-controlled oscillator.

4. Device according to any one of the preceding claims, comprising means for prohibiting the use of the electrical apparatus (1) as a function of the estimation of the resistance of the earth connection (5).

5. Device according to any one of the preceding claims, in which the electrical apparatus (1) is a battery charger for automotive vehicle with electric or hybrid traction.

6. Method for estimating the resistance of the earth connection (5) of an electrical apparatus (1) when the said electrical apparatus is connected to an electrical supply network and also connected to the earth by an additional resistance (6), the said estimating method being **characterized in that** a current is generated between an input impedance of the electrical apparatus and the resistance of the earth connection (5) and that the current flowing to earth (It) across the said resistance of the earth connection (5) is measured, so as to obtain an order of magnitude of the resistance of the earth connection (5) with respect to the value of the said additional resistance (6),
the leakage current is measured on the basis of the differential electrical supply current, and the additional resistance (6) is estimated as a function of the leakage current and of the current flowing to earth (It),
and the resistance of the earth connection (5) and the additional resistance are estimated by means of a table comprising values of resistance of the earth connection (5), values of additional resistance (6) and values of current flowing to earth corresponding to the said values of resistance of the earth connection and to the said values of additional resistance.

7. Method according to Claim 6, in which a sinusoidal current is generated across the resistance of the earth connection (5).

8. Method according to either of Claims 6 and 7, in which the use of the electrical apparatus (1) is prohibited as a function of the estimation of the resistance of the earth connection.

9. Method according to Claim 8, in which the use of the electrical apparatus (1) is prohibited if the resistance of the earth connection is higher than the additional resistance.
